# EUROPEAN PATENT APPLICATION

(11) **EP 2 124 267 A2**
(43) Date of publication of application: **25.11.2009**
(21) Application number: 09159609.8
(22) Date of filing: 07.05.2009
(51) Int. Cl.: H01L 35/30, A61N 1/08

(54) **Thermoelectric generator for implants and embedded devices**

(30) Priority: 22.05.2008 US 55162 P
(71) Applicant: Stichting IMEC Nederland, 5656 AE Eindhoven (NL)
(72) Inventor: Leonov, Vladimir, 3010, Leuven (BE)
(74) Representative: Hertoghe, Kris Angèle Louisa

(57) **Abstract**

The present invention provides a TEG device (40) comprising a first unit (60) comprising a thermopile unit (50) and a second unit comprising a cold plate (38) and/or a radiator (48). One of the first and second units (60, 70) is adapted for being embedded or implanted into a body (61), while the other of the first and second units (60, 70) is adapted for being placed at the outer surface of the body (61), i.e. in a fluid (62). The first and second units (60, 70) are adapted for being thermally connected to each other through the surface (59) between the body (61) and the fluid (62) when in use.

## Description

### Technical field of the invention

The present invention relates to power supplies and to thermoelectric generators (TEGs) and more in particular to TEGs comprising an implantable or embedded unit and a wearable or external unit. The TEGs of the present invention can be used for powering embedded devices or implanted devices, for example devices implanted in the body of an endotherm such as a human being or an animal, or devices embedded in mechanical structures like tubes or pipes.

### Background of the invention

A thermoelectric generator (TEG) utilises a temperature difference occurring between a hot (warm) object, i.e. a heat source, and its colder surroundings, i.e. a heat sink, or vice versa, and can be used to transform a consequent heat flow into useful electrical power.

There is an increasing interest in implantable devices, e.g. devices that can be implanted into a human body or into an animal. Examples of such devices include active implantable medical devices such as drug delivery devices, communication devices, stimulating devices, devices for support of biological processes, and other therapeutic and diagnostic devices, e.g. brain stimulators, cardiac stimulators and cochlear implants. All of these devices require a power source, such as a battery, which has a limited lifetime. Because of the limited lifetime of batteries, there is a need for regular replacement through surgery. In order to avoid this need, thermoelectric generators may be used instead of or in addition to batteries for powering implantable devices.

Implantable devices powered by a thermoelectric power source are for example described in US 6,131,581, US 6,470,212, US 6,640,137, US 7,127,293, WO 2005 044369, WO 2006 017226, and WO 2006 031395. These prior art thermoelectric power sources utilize naturally available temperature differences inside the human or animal body to generate electricity. These naturally available temperature differences inside the human or animal body are usually very small on average. This small temperature difference is usually less than 1 °C, which can be too small to allow the generated thermoelectric power to completely power many types of implantable medical device. Therefore, the power that can be generated by a TEG based on such small temperature differences may be insufficient for reliably powering an implanted device, and regular replacement of an implanted battery may still be needed, as e.g. described in US 6,640,137.

### Summary of the invention

It is an object of embodiments of the present invention to provide a TEG that is able to reliably power an implanted or embedded device. It is an object of particular embodiments of the present invention to increase the temperature differences available inside the human or animal body and to provide a TEG that is suitable for using such temperature differences to generate electricity.

One aspect of the present invention is a thermoelectric generator (TEG) device having a first unit comprising a thermopile unit and a second unit comprising a cold plate and/or a radiator. One of the first and second units is implantable or embeddable and can for example be placed inside a human or animal body, or inside a mechanical structure such as a tube or pipe. The other one of the first and second units is a wearable or external unit and may for example be placed on the skin of a human or animal body, or on the outer surface of the mechanical structure such as a tube or pipe. According to the present invention, the wearable or external unit and the implantable or embeddable unit are adapted for being thermally connected to each other when in use.

Both the implantable or embeddable unit and the wearable or external unit can be designed such that a natural heat flow, e.g. a heat flow resulting from heat produced in the human or animal body or inside a mechanical structure, is directed more efficiently into the thermopile unit. This can lead to a higher power generation as compared to prior art implantable TEGs.

In certain embodiments of the present invention, the heat flow through a first unit, e.g. an implantable or embeddable unit, that is thermally connected to a second unit, e.g. a wearable or external unit, can be improved. The first unit can comprise means for improving the heat flow therethrough. For example, in embodiments of the invention the first unit can comprise a thermally conductive thermal matching plate, wherein the size of the thermal matching plate is substantially larger than the size of the thermopile unit in a direction parallel to the average plane of the matching plate. The first unit can further comprise a hot plate or heat absorbing plate wherein the size of the hot plate is substantially larger than the size of the thermopile unit in a direction parallel to the average plane of the hot plate. In embodiments of the invention, the second unit can comprise a cold plate, e.g. as part of a radiator, wherein the size of the cold plate is substantially larger than the size of the thermopile unit in a plane parallel to the average plane of the cold plate. In other embodiments of the invention, the first unit can further comprise a thermally insulating element surrounding the thermal matching plate in a direction parallel to the average plane of the thermal matching plate, the size of the thermally insulating element being larger than the size of the thermal matching plate and being optionally larger than the size of the cold plate of the second unit in a plane parallel to the average plane of the thermal matching plate. In certain embodiments of the invention, the second unit can comprise a thermally conductive element, e.g. a thermally conductive ring, surrounding the cold plate in a direction parallel to the average plane of the cold plate, the size of the thermally conductive element being larger than the size of the cold plate and preferably larger than the size of the thermal matching plate of the first unit in a plane parallel to the average plane of the cold plate. These different elements (e.g. thermal matching plate, hot plate, cold plate, radiator, thermally insulating element surrounding the thermal matching plate, thermally conductive element surrounding the cold plate) can be designed and positioned such that, when the device of embodiments of the present invention is in use, they provide a redirection of a natural heat flow into the thermopile unit of the implantable or embeddable unit.

In certain embodiments of the present invention, alignment structures are provided to align the first and second units with each other and/or for detecting proper positioning of the wearable or external unit with respect to the implantable or embeddable unit. Such alignment structures can, for example, comprise coils or Hall sensors and magnets. Furthermore, signal transmitters and receivers may be included to provide for communication between the first unit and the second unit and/or with a remote device.

In certain aspects, the invention provides a device comprising a thermoelectric generator for powering implanted or embedded devices, e.g. for powering devices implanted in a human or animal body, wherein the small temperature differences that are naturally available, e.g. in a human or animal body, are converted efficiently into an electrical output power as compared to prior art implantable thermoelectric generators. In alternative embodiments, the invention provides a device comprising a thermoelectric generator for powering devices embedded into a mechanical structure such as e.g. a tube or pipe.

In a further aspect of the present invention, a wearable or external unit of a TEG device is provided, which wearable or external unit comprises a thermopile unit or a combination or a cold plate and/or a radiator, the wearable unit being adapted for being placed on or near an interface between an object and surrounding fluid, and adapted for being thermally connected to an embedded unit embedded in the object.

These and other characteristics, features, peculiarities and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1 shows a TEG according to one embodiment of the present invention, comprising an implantable unit or an embedded unit and a wearable unit or an external unit.
Fig. 2 shows the heat flow pattern (a) in/around an entirely implanted prior-art device (left), and (b) in/around a TEG according to one embodiment of the present invention.
Fig. 3 shows a TEG according to embodiments of the present invention which has a wearable or external unit with a pin/fin radiator, while the implantable or embeddable unit has a large heat absorbing plate or hot plate, a thermal matching plate and side isolation.
Fig. 4 shows a TEG according to embodiments of the present invention for use in/on a head of a human being or for an animal with a coat, wherein an external thermal shunt comprising comb-like or brush-like thermally conductive pins/fins shunts the thermal resistance of hair.
Fig. 5 shows a TEG according to embodiments of the present invention with an implantable or embeddable unit comprising a multi-stage thermopile unit, a curved heat absorbing plate, a thermally insulating and encapsulating wall and a thermally insulating ring, and with a wearable or external unit comprising thermally conductive pillars, a solar cell and an electronic module powered by the solar cell.
Fig. 6 shows a TEG according to embodiments of the present invention with an implantable or embeddable unit comprising self-supported or membrane-type thermopiles and a vacuum insulation in a thermally insulating ring and with a wearable or external unit comprising a radiator with pins/channels. Furthermore a thermal ring and a second radiator are provided.

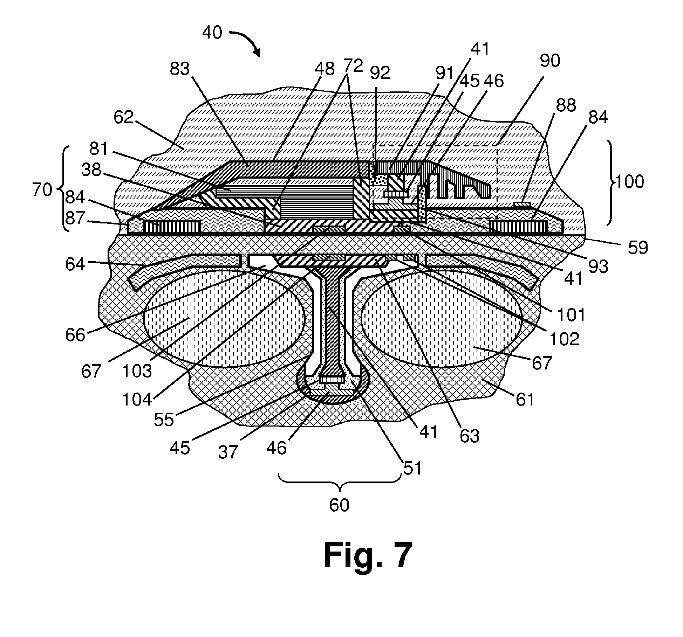

Fig. 7 shows a TEG according to one embodiment of the present invention and a device powered by such TEG. The implantable or embeddable unit of the TEG comprises a micromachined thermopile unit, magnets and coils for alignment of the wearable or external unit with respect to the implantable or embeddable unit and for transmission of signals through a surface of the body where the implantable or embeddable unit is implanted or embedded, e.g. through the skin. The external or wearable unit comprises an additional TEG to power a wearable electronic module, a Hall sensor for alignment of the wearable or external unit and the implantable or embeddable unit, coils for communication with the implantable or embeddable unit, and an antenna for further communication to a remote device.
Fig. 8 shows a TEG according to one embodiment of the present invention comprising a thin thermopile unit implanted in the human wrist and a wearable or external radiator.
Fig. 9 shows a TEG according to one embodiment of the present invention wherein the implantable or embeddable unit and the wearable or external unit are provided with inductive and radiant communication systems for transmitting signals through a surface, e.g. the skin.
Fig. 10 shows a TEG according to one embodiment of the present invention with a flexible wearable or external unit.
Fig. 11 shows a TEG according to one embodiment of the present invention wherein the thermopile unit is implanted in the head of an endotherm.

In the different figures, the same reference numbers refer to the same or analogous elements.

### Description of illustrative embodiments

In the following detailed description, numerous specific details are set forth in order to provide a thorough understanding of the invention and how it may be practiced in particular embodiments. However it will be understood that the present invention may be practiced without these specific details. In other instances, well-known methods, procedures and techniques have not been described in detail, so as not to obscure the present invention. While certain aspects of the present invention will be described with respect to particular embodiments and with reference to certain drawings, the invention is not to be limited thereto. The drawings included and described herein are schematic and are not meant to limit the scope of the invention. It is also noted that in the drawings, the size of some elements may be exaggerated and, therefore, not drawn to scale for illustrative purposes.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the steps or elements listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

In one aspect, the present invention provides a TEG device comprising a first unit comprising a thermopile unit, and a second unit comprising a cold plate and/or a radiator. One of the first or second units is an embeddable unit adapted for being embedded in an object, and the other one of the first or second units is an external unit adapted for being placed on or near an interface between the object and a surrounding fluid. The embeddable unit and the external unit are adapted for being thermally connected to each other.

In the following description and corresponding drawings, the first unit comprising the thermopile unit is always illustrated as the embeddable unit, while the second unit comprising the cold plate and/or the radiator is always illustrated as the external unit. This is, however, not intended to be limiting to the present invention; inverse configurations where the first unit comprising the thermopile unit is an external unit while the second unit comprising the cold plate and/or the radiation is the embeddable unit form also part of the present invention. In the case of implanting a part of a TEG in a human body it will be the hot plate which is implanted. However, in case of pipes this may be different; for example in case of a pipe with a cold liquid e.g. cold water flowing inside the hot plate may be located at the outside of the pipe.

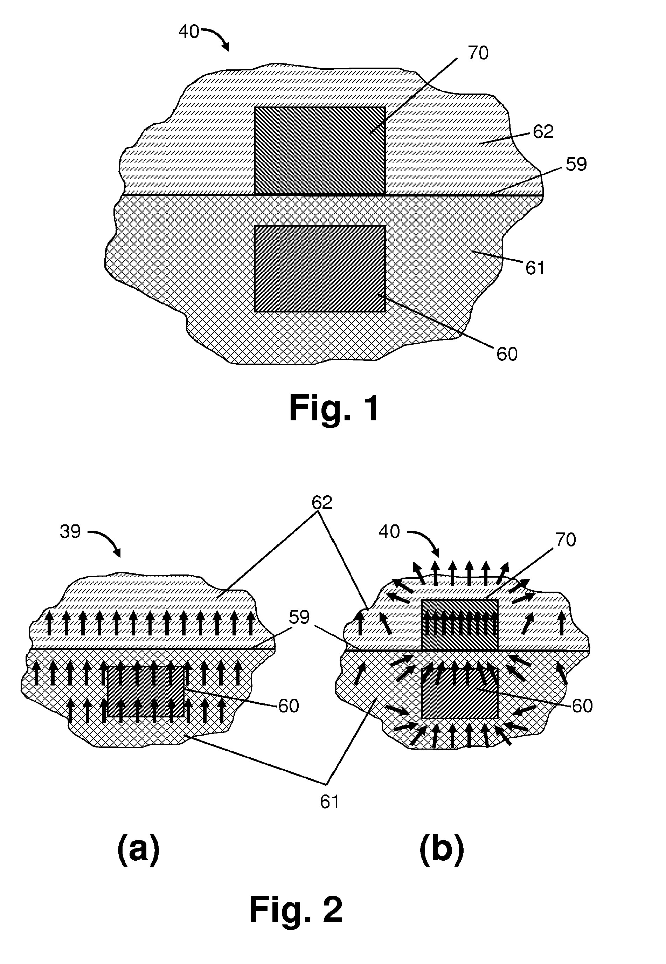

A TEG 40 according to one aspect of the present invention is illustrated in Fig. 1. The TEG 40 comprises an implantable unit or embeddable unit 60 suitable for being placed into an object 61 and a wearable unit or external unit 70 suitable for being placed on or near the interface between the object 61 and the surrounding fluid 62.

TEGs according to certain embodiments of the present invention are further below described for the particular case wherein the object 61 is a body of an endotherm, such as a human being or an animal, and wherein unit 60 is an implantable unit that can be implanted in a body, e.g. a human or animal body. The surrounding fluid 62 may, for example, be a gas such as air. The skin 59 then forms the interface between the object 61, e.g. human or animal body, and the surrounding fluid 62, e.g. air. The implantable unit 60 can be used for powering other implanted devices, such as for example implanted medical devices such as drug delivery devices, communication devices, stimulating devices, devices for support of biological processes, therapeutic or diagnostic devices. However, notwithstanding these examples, the TEGs of the present invention can also be used in other applications. For example, an embedded unit 60 may be placed in a mechanical object 61 such as for example a pipe, e.g. a plastic pipe, while an external unit 70 may be placed on an outer surface of the pipe or vice versa. The surrounding fluid 62 may also be a gas such as air. In alternative embodiments, the surrounding fluid may be a liquid, such as for example water. Other applications are also possible. Thus, although the examples given below relate to implantation of an embeddable part of the TEG into a human body, they are equally well applicable to implantation of the embeddable part into any suitable body, such as for example a mechanical structure. "Skin" then may be replaced by "surface between the body and a surrounding medium".

In certain embodiments of the present invention, the implantable unit 60 of a TEG 40 comprises a thermopile unit. When a temperature difference, e.g. a natural temperature difference, exists between the object 61, e.g. a human or animal body and the surrounding fluid 62, e.g. air, a resulting heat flow through the thermopile unit can result in the generation of an output voltage and output power. For example, a natural heat flow on the skin 59 of e.g. about 3 mW/cm2 may be present. The implanted thermopile unit of the implantable unit 60 produces a voltage and a power output as a result of a small natural temperature gradient which is present inside the body (as a function of the distance from the skin 59). However, this small temperature difference is usually less than 1 °C, which can often be insufficient to completely power an implantable (e.g. medical) device. Accordingly, in certain embodiments of the present invention a wearable unit 70 is attached to the skin 59 at the outer side, i.e. the side facing away from the object 61. In use, the wearable unit 70 and the implantable unit 60 are thermally connected to each other, through the skin 59. The wearable unit 70 and the implantable unit 60 being thermally connected means that the thermal resistance between the wearable unit 70 and the implantable unit 60 is preferably low, such that efficient heat transfer between both units is obtained. The wearable unit 70 serves to redirect the heat produced in the body more efficiently into the thermopile unit of the implantable unit 60. The wearable unit 70 also decreases the thermal resistance of the body 61 and the air 62 and reduces the skin temperature. As the thermal resistances of the human or animal body 61 and the ambient air 62 are both in series with the thermal resistance of the thermopile unit, this leads to an increased heat flow through the implantable unit 60. The wearable unit 70 can, for example, comprise a radiator and its presence can substantially increase the heat flow through the implantable unit 60, for example it may increase this heat flow with a factor of 2 to 5 or more. The design of units 60 and 70 is preferably performed in accordance with the thermal matching conditions described in US 2008/314429.

The result of providing the wearable unit 70 outside the body 61 is that the heat flow in the vicinity of the implantable unit 60 transforms from a one-dimensional heat flow to a three-dimensional one, as illustrated in Fig. 2. In Fig. 2(a) the arrows show the heat flow between the object 61 and the surrounding fluid 62 in case of a prior art implantable TEG 39, only comprising an implantable unit 60. In Fig. 2(b), the arrows show the heat flow between the object 61 and the surrounding fluid 62 with an implantable TEG 40 according to embodiments of the present invention, wherein the TEG 40 comprises an implantable unit 60 and a wearable unit 70 thermally connected to the implantable unit 60. As can be seen in Fig. 2(b), the wearable unit 70 causes a redirection of the natural heat flow through the implantable unit 60, while the overall heat losses from the body 61 remain the same. The implantable unit 60 comprising a thermopile unit and the wearable unit 70 comprising a radiator are connected thermally to each other through e.g., the skin 59 of a person.

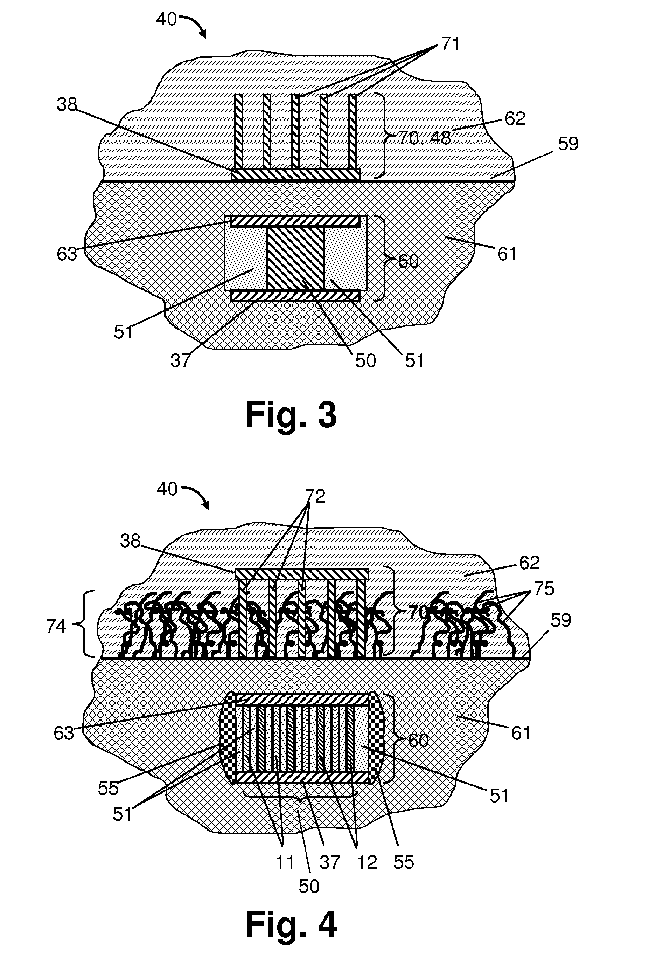

A TEG 40 according to one embodiment of the present invention is illustrated in more detail in Fig. 3. The implantable unit 60 comprises a thermopile unit 50, wherein the thermopile unit 50 comprises at least one thermopile comprising a plurality of thermocouples that may be for example connected electrically in series and thermally in parallel (however, other electrical connection configurations are possible). The thermopile unit 50 is placed in between a thermally conductive hot plate 37 and a thermally conductive thermal matching plate 63. The thermal matching plate is used for improving the thermal connection (i.e. reducing the thermal resistance) between the thermopile unit and the wearable unit, by thermally shunting the skin. The thermal resistance is inversely proportional to the square of the die area. For example, if no thermal matching plate would be present, a typical size of the implantable unit in a plane parallel to the skin would be 4 mm². By adding a thermal matching plate (and a cold plate) having a size of e.g. 2 cm x 2 cm, the thermal resistance can be reduced by a factor of 100. The wearable unit 70 comprises a cold plate 38. Both the thermal matching plate 63 and the cold plate 38 have a size that is substantially larger, preferably at least two times larger, more preferred at least three times larger, than the size of the thermopile unit 50 in a direction parallel to the average plane of the thermal matching plate 63, which in the embodiment illustrated is substantially parallel to the surface of the skin 59, leading to an improvement of the heat transfer (i.e. a reduction of the thermal resistance) between the implantable unit 60 and the wearable unit 70 as compared to a situation where there is no or a smaller cold plate 38 and/or thermal matching plate 63. The thermopile unit 50 and TEG 40 can further comprise other elements. For example, a thermal insulation 51 can be present next to the thermopile unit 50 and in particular embodiments surrounding the thermopile unit 50 or encapsulating the thermopile unit 50 from all sides except the sides towards plates 37 and 63. The thermal insulation 51 may be formed by a thermally insulating material, and can comprise pillars or walls in between the hot plate 37 and the thermal matching plate 63. In the embodiment of Fig. 3, the wearable unit 70 comprises a cold plate 38 and thermally conductive pins or fins 71. The pins/fins 71 together with the cold plate 38 form a radiator 48, which serves to increase the heat flow through the thermopile unit 50 as compared with the natural heat flow occurring at the interface between object 61 and surrounding fluid 62 in the absence of a radiator 48. In addition, radiator 48 serves to decrease the thermal resistance of the body as has been described by V. Leonov and R. J. M. Vullers in "Thermoelectric generators on living beings", Proceedings of the 5th European Conference on Thermoelectrics, Odessa, Ukraine, Sep. 10-12, 2007, pp. 47-52. The TEG 40 preferably follows or at least approaches the thermal matching conditions according to US 2008/314429.

A TEG 40 according to another embodiment of the present invention is illustrated in Fig. 4. In this embodiment, the implantable unit 60 comprises a thermopile unit 50, comprising a thermopile with a plurality of thermocouples electrically connected in series and thermally connected in parallel, each thermocouple comprising a first thermocouple leg 11 and a second thermocouple leg 12 formed of different thermoelectric materials. The thermopile unit 50 is placed in between a hot plate 37 and a thermal matching plate 63. The implantable unit 60 has a thermally insulating wall 55 encapsulating the volume in between the plates 37 and 63. The implantable unit 60 can further comprise other elements. For example, a thermal insulation 51 can surround the thermopile unit and fill the space in between the thermocouple legs 11, 12. This thermal insulation 51 can, for example, be formed from vacuum, a gas or another thermally insulating material. It also may include additional thermally insulating pillars interconnecting the plates 37 and 63, or/and such pillars may replace the wall 55. In the embodiment of Fig. 4, the wearable unit 70 comprises a cold plate 38 and an outer thermal shunt 74 comprising thermally conductive pins or fins 72. The wearable unit 70 as shown in Fig. 4 can be worn on top of e.g. hair 75 of a person or a coat of an animal, or feathers of a bird. The outer thermal shunt 74 is used to thermally shunt the layer of hair 75, thereby providing a low thermal resistance between the skin 59 and the cold plate 38. A radiator 48 can be used on top of a cold plate 38. The implantable unit 60 and the wearable unit 70 can further comprise other elements. The thermally optimized TEG 40 preferably follows the thermal matching condition according to US 2008/314429.

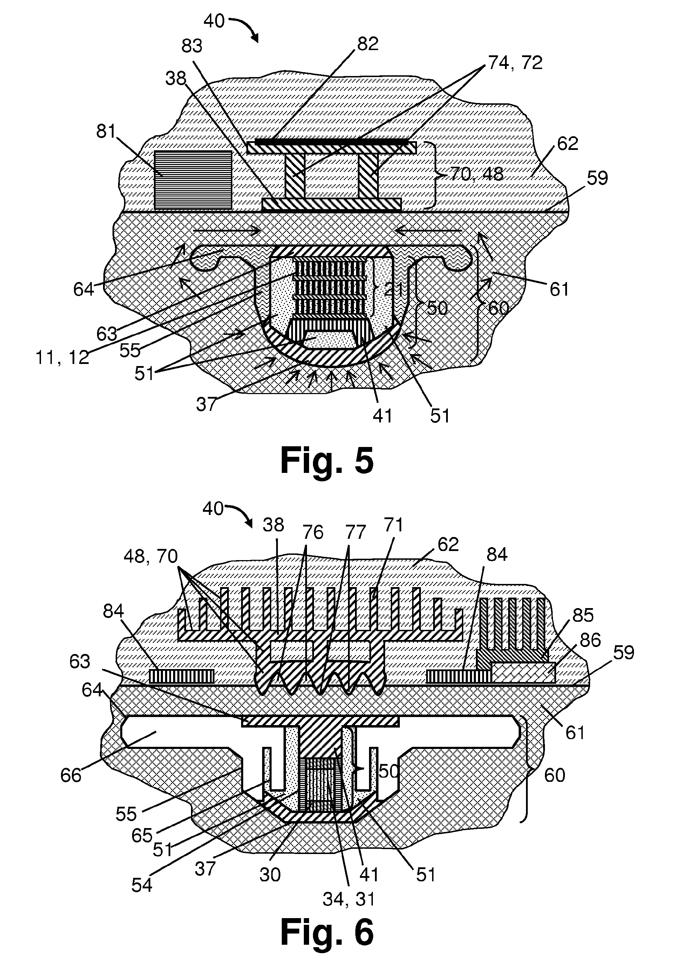

A TEG 40 according to another embodiment of the present invention is illustrated in Fig. 5. In this embodiment, the implantable unit 60 comprises a thermopile unit 50, comprising thermopiles 21 in a multi-stage assembly according to US 2008/314429, on a thermally conductive spacer 41, the thermopile unit 50 being sandwiched between a hot plate 37 and a thermal matching plate 63. With this configuration a better thermal matching of the TEG 40 with the environment may be obtained as compared with a thermopile unit 50 comprising a single thermopile stage. In the example illustrated in Fig. 5, a three-stage thermopile unit 50 is shown and a cup-shaped spacer 41. Other configurations and shapes are possible. The implantable unit 60 shown in Fig. 5 comprises a thermally insulating element, such as for example a thermally insulating ring 64, surrounding the thermal matching plate 63, at least in a direction parallel to the average plane of the thermal matching plate 63, which in the embodiment illustrated is substantially parallel to the surface of the skin 59, at least locally where the skin 59 is closest to the thermal matching plate 63. The thermally insulating element may be tube shaped, whereby a wall of the tube has an L-shaped cross-section in a direction along the longitudinal axis of the tube. This thermally insulating element or ring 64 helps to increase the heat flow through the wearable unit 70, thereby decreasing the temperature of a tissue/skin 59 located in between the wearable unit 70 and the thermal matching plate 63, thus leading to a higher power and a higher voltage generation by the TEG 40. The thermally insulating element 64 can have any other suitable shape different from a ring shape, such as for example a square shape, or a semi-ring like U-shape, etc. As is clear from Fig. 2(b), the heat flow occurring in the body 61 near implantable unit 60, from its edges to the skin 59 under the external or wearable unit 70, is a parasitic heat flow, because it bypasses the unit 60. By providing an insulating element such as an insulating ring 64 (as shown in Fig. 5) in an area corresponding to the area where such a parasitic heat flow would occur, this parasitic heat flow can be reduced or avoided and the heat flow through the implantable unit 60 can be further improved as compared to a configuration without such an insulating element, e.g. ring 64. The insulating element 64 causes an increase of the thermal resistance between the implantable unit 60 and the wearable unit 70 in the area where the insulating element 64 is located, as compared to the embodiments shown in Fig. 3 and Fig. 4. The size of the insulating element 64 in a direction parallel to the plane of the thermal matching plate 63 is preferably larger than the size of the cold plate 38 of the wearable unit 70. The hot plate 37 has a hemi-ellipsoidal shape in the particular case shown in Fig. 5, resulting in a further increase of the heat flow through the implantable unit 60 because of the larger surface area of the hot plate 37. The implantable unit 60 has a thermally insulating wall 55 encapsulating the volume in between the plates 37 and 63. This insulating wall 55 may be part of the tube shape of the thermally insulating element 64 as discussed above. In the particular embodiment shown, the ring 64 and the wall 55 are made as one component. The implantable unit 60 can further comprise other elements. A thermal insulation 51 can surround the thermopile unit 50 and/or fill the space in between the thermocouple legs 11, 12. It can be formed, for example, from vacuum, a gas or another thermally insulating material. It also can include additional thermally insulating pillars interconnecting at least two of the components 37, 64, 55, 41 and 63. In the embodiment of Fig. 5, the wearable unit 70 comprises a cold plate 38 and outer thermal shunts 74 comprising thermally conductive elements, e.g. pillars 72.

In Fig. 5 an electronic module 81 is shown, as an example of a wearable device that can be used in combination with a TEG 40 according to embodiments of the present invention. In embodiments of the present invention, the module 81 can be attached to the skin 59 by means of a watchstrap or a bracelet or an elastic band (not illustrated in the drawing), by integrating it in clothes (not illustrated) and pushing it onto the skin using elastic bands in the clothes, by means of a plaster (e.g. a medical strap sticking to the skin 59) (not illustrated), by means of springs (not illustrated), by means of magnets e.g. in the implanted unit 60 and in the electronic module 81, by velcro-connection to clothes (not illustrated), ... The electronic module 81 may for example comprise power conditioning, electronic and/or wireless modules. The electronic module can, for example, generate an alarm signal if the wearable unit 70 and/or the electronic module 81 are not attached or not properly attached to the skin 59. Such an alarm signal can be transmitted wirelessly to a nearby base station, such as e.g. a PC or a cellular phone or any other wireless device. Alternatively, the electronic module 81 can generate a light signal or a sound signal if the wearable unit 70 and/or electronic module 81 are not attached or not properly attached to the skin 59. The electronic module 81 can transmit and/or receive information, e.g. from an implanted device (not shown), for example through an inductive link with the implanted device or with implantable unit 60, and further transmit this information received to a base station or to another external device.

To power this electronic module 81, a photovoltaic cell 82, e.g. a photovoltaic cell 82 on a substrate 83, e.g. a semiconductor substrate such as a silicon substrate, can for example be used. The photovoltaic cell 82 may be thermally attached to the thermally conductive elements, e.g. pillars 72. This photovoltaic cell 82 may serve as a part of a radiator 48 according to US 12/397888. US 12/397888 describes a hybrid energy scavenger comprising a thermopile unit 50 being placed between a hot plate 37 and a thermally conductive heat dissipating structure, wherein the heat dissipating structure comprises at least one photovoltaic cell. The at least one photovoltaic cell can be mounted on, and thermally connected to, an element of the heat dissipating structure. The at least one photovoltaic cell can be used as a structural element of the heat dissipating structure. In embodiments of this invention the heat dissipating structure may for example comprise a radiator 48 or a cold plate shaped as a radiator 48, the radiator 48 being placed in between the thermopile unit 50 and the at least one photovoltaic cell. The at least one photovoltaic cell can generate an electrical output which can be used in addition to, or as an alternative to, an electrical output from the thermopile unit. The presence of the human or animal skin 59 at the cold plate 38 can e.g. be detected by a thermocouple or a pair of thermocouples thermally connected to the skin 59 and to the substrate 83. The electronic module 81 can also generate an alarm signal when the temperature of the skin 59 is too close to the ambient temperature for a prolonged period of time to provide sufficient energy, e.g. for powering an implanted device. The period of time to be considered depends, inter alia, on the charge storage capability of a charge storage element that can be used in combination with the implantable unit 60. Such a charge storage element may be for example an ultracapacitor, a NiMH or NiCd battery, or a rechargeable Li battery, which may serve as a main source of power and is recharged almost constantly by the TEG 40, or which is recharged during day time only, depending on the design and location in the body. When the temperature of the skin 59 is too close to ambient temperature for a prolonged period of time, the power generated by the implantable unit 60 can in some circumstances be too low for powering an implanted device. In order to avoid problems with power being too low for powering the implanted device, a supplementary battery (not illustrated) may also be implanted, serving as a backup for powering the implanted device such as e.g. a pacemaker, in case the TEG 40 would not provide sufficient energy to power the implanted device. Electronics can be provided for switching to the supplementary battery as a main source of power if the rechargeable battery is low on power.

Yet another embodiment of a TEG 40 according to the present invention is illustrated in Fig. 6. In the example shown, the implantable unit 60 comprises a thermopile unit 50, comprising a plurality of thermopile chips 30 (8 chips are shown in Fig. 6) according to US 2008/271772, each thermopile chip comprising a plurality of thermopiles. In this embodiment of the invention, a thermally conductive spacer 41 is provided in between the thermopile chips 30 and the thermal matching plate 63, which can help to provide better thermal matching of the TEG 40 with the environment. Thermally insulating pillars or walls 54 can support the thermopile chips 30 during assembly of the unit 60 and can optionally be removed after rigid fixing of the positions of the thermally insulating element 64, if present, and the thermal matching plate 63 and hot plate 37 with respect to each other. In the particular case shown in Fig. 6, the thermal matching plate 63 and the spacer 41 represent one component. The implantable unit 60 comprises a thermally insulating element 64 around thermal matching plate 63, hot plate 37 and thermopile unit 50. The thermally insulating element 64 is combined here with a thermally insulating wall 55, as also disclosed with reference to Fig. 5. The thermally insulating element 64 shown in Fig. 6 can be made of a vacuum-tight thin material such as stainless steel, glass, covar (e.g., KOVAR^{™}), etc., and the inner space 66 of this thermally insulating element can be under vacuum, preferably below 0.001 mbar. The inner surface of the thermally insulating element 64 preferably has a low emission coefficient in the infrared, preferably less than 0.02. In the example shown in Fig. 6, a thermal insulation 51 surrounding the thermopile unit 50 comprises a meandered part 65 for decreasing a parasitic heat exchange between the hot plate 37 and the thermal matching plate 63. As is clear from Fig. 2(b), the heat flow occurring in the body 61 above the implantable unit 60, on its edges, and arriving to the skin 59 under the unit 70, decreases the temperature difference between the thermal matching plate 63 and the hot plate 37, because it bypasses the implantable unit 60. Therefore, in the particular embodiment shown in Fig. 6, some additional components are provided in addition to implantable unit 60 and wearable unit 70 in order to avoid this effect. For example, a wearable or external thermally conductive element, e.g. a thermal ring 84, may be used to minimize or to block completely the parasitic heat flow in the part of the body 61 between implantable unit 60 and external unit 70 (i.e. the heat flow which is bypassing the implantable unit 60). The thermally conductive element 84 may be placed to surround the cold plate 38 or another portion of the external unit 70 in a direction parallel to the average plane of the cold plate 38. The diameter or outer dimension of the thermally conductive element 84 may be larger than the diameter or outer dimension of the cold plate 38. The inner dimension of the thermally conductive element 84 may be larger than the outer dimension of the cold plate 38. The temperature of this thermally conductive element, e.g. thermal ring 84, and the heat flow through it may be maintained at a level allowing keeping the temperature of the skin 59 in between the thermally conductive element, e.g. thermal ring 84, and the thermally insulating element, e.g. ring 64, of the implantable unit 60 (further denoted as "A") close to the temperature of the skin 59 between the wearable unit 70, e.g. the cold plate 38 thereof, and the thermal matching plate 63 (further denoted as "B"). When there is a heat flow from the object 61 into the surrounding fluid 62, the temperature "A" is preferably lower than the temperature of an open skin surface, i.e. with no thermally conductive element, e.g. ring 84 ("Case 1"). It is more preferable that the temperature "A" under thermally conductive element, e.g. ring 84 is not higher than, for example equal to, temperature "B" ("Case 2"), and still more preferable that "A" is less than "B" ("Case 3"). In Case 1, the power generated by the TEG 40 increases as compared with the previously shown designs of a TEG 40 without a thermally conductive element, e.g. ring 84. In Case 2, there is no parasitic heat exchange between the zone with the temperature "A" and the zone with the temperature "B", because both temperatures are equal. This situation can allow the achievement of near-perfect thermal matching conditions as stated in US 2008/314429. In Case 3, the thermally conductive element, e.g. ring 84 further improves the heat flow through the thermopile unit 50 as compared with Case 2. The control of the temperature of the thermally conductive element, e.g. ring 84 can be provided by at least one radiator 85, or several radiators 85. These radiators 85 can be attached and thermally connected to the thermally conductive element, e.g. thermal ring 84, and they can allow the redirection of the parasitic heat flow into thermally conductive element, e.g. thermal ring 84 and into radiator 85 instead of into wearable unit 70. The radiator 85 may be made flat, similar to a cold plate 38, or it may be have any shape suitable for dissipating heat, e.g. it may be shaped similar to a radiator 48. The radiator 85 may be thermally insulated from the skin surface, e.g. by means of a thermally insulating material 86. The location of a radiator 85 may be such that it does not decrease the heat transfer from the radiator 48. The wearable unit 70 shown in Fig. 6 is made of one piece of thermally conductive material and its cold plate 38 with pins 71 can be kept at a pre-determined distance from the body 61 in accordance with US 2008/314429, in order to improve the Rayleigh/Reynolds numbers. In the particular case shown in Fig. 6, the surface of unit 70 touching the skin 59 is made with channels 76 parallel to the skin surface or/and pins/fins 77 touching the skin 59, to facilitate evaporation of sweat from the skin surface and thus further decrease the thermal resistance to ambient fluid, e.g. air. Other advantages of this approach are that the TEG 40 can operate at higher ambient temperatures, that it can function more reliably, and that it can allow a more pleasant experience for the user (e.g., no wetting of the skin 59 under the external unit 70). Similar channels as the channels 76 underneath the external unit 70 can be made (not illustrated in the drawings) in the thermally conductive element, e.g. thermal ring 84, in the thermally insulating material 86, in the electronic module 81, in the cold plate 38, or/and in any other component of the TEG 40 that is in contact with the skin 59. A thermal insulation 51 can surround the thermopile unit 50 and/or fill the space in between the thermocouple legs 31, or/and membranes 34 on neighbouring thermopile chips 30. The TEG 40 can further comprise other elements, for example elements illustrated and described with respect to other embodiments of the present invention.

The particular shapes of the components of TEGs 40 according to embodiments of the present invention can vary appreciably from device to device. Another example of a wearable device 100 comprising a wearable unit 70 according to embodiments of the present invention is illustrated in Fig. 7. A wearable device 100 according to the principles as illustrated in Fig. 7 can be useful in a case where an implantable unit 60 is to be implanted at locations where only a limited space is available, e.g. into the chest of an animal or a human being, in which the rib cage with ribs 67 can present a problem for prior art devices. In the embodiment of Fig. 7, the implantable unit 60 comprises a thermopile assembled from two chips according to US 2006/0000502. The thermopile according to this embodiment of the invention comprises a die 45 and a heat-spreading chip 46, and a thermally conductive spacer 41 in between the die 45 and the thermal matching plate 63. In the example shown, the hot plate 37 is curved to decrease the thermal resistance of the body 61 and has a size that allows it to be passed between the ribs 67 e.g. during surgery. The hot plate 37 can extend for several centimetres along the ribs 67 if more power is required for an implanted device powered by the TEG 40. A thermally insulating encapsulation 55 being part of the implantable unit 60 and encapsulating a volume in between the hot plate 37 and the thermal matching plate 63 comprises an inner space 66, which can e.g. be under reduced pressure or under vacuum. The part of the thermally insulating encapsulation 55 which is in between the ribs 67 can for example be cylindrical, elliptical or can have any other suitable shape. Near the thermal matching plate 63, it can widen and partially perform functions of a thermally insulating element, e.g. ring 64 as discussed before. In the example shown in Fig. 7, the main part of a thermally insulating element, e.g. ring 64 is made separate from the implantable unit 60 and the thermally insulating encapsulation 55. It can for example be made from a soft sheet of thermally insulating material, e.g., from biocompatible materials with low thermal conductivity, such as for example parylene, silicon dioxide, silicon nitride or materials such as for example silicon oxide foam, glass foam, silicone foam or polyurethane foam. It can be any material with low thermal conductivity such as for example a nanoporous material, e.g. coated with biocompatible materials.

In the embodiment of Fig.7, the wearable device 100 is shown to comprise a wearable unit 70, and an electronic module 81 placed in between a radiator 48 and a thermally conductive cold plate 38, and partially surrounded by thermally conductive walls or pillars 72. The components 38, 72 and 48 serve to redirect the heat flow into the implantable unit 60 and in addition they serve as a case for the electronic module 81. This module can be powered by a battery, by solar cells, or, , by an additional wearable or external TEG 90, or by a combination of the above. The additional TEG 90, also shown as a part of the wearable device 100 in the embodiment illustrated in Fig. 7, can be an independent wearable or external device, or can be made on top of a wearable thermally conductive element, e.g. thermal ring 84 forming part of the external unit 70. More in particular, in embodiments of the present invention the additional TEG 90 can be placed in between the thermally conductive element, e.g. ring 84 and the radiator 85 shown in Fig. 6. It can also be manufactured in between the thermally conductive element, e.g. ring 84 and the remainder of the wearable unit 70, or inside the wearable unit 70, e.g. in between the cold plate 38 and the radiator 48, or, as shown in Fig. 7, the TEG 90 may be fabricated next to the unit 70 on the same cold plate 38, occupying a part of it. In the particular case shown in Fig. 7, the thermopile of the additional wearable TEG 90 comprises a die 45 and a heat-spreading chip 46, and two thermally conductive spacers 41. A radiator 91 is provided for reducing the thermal resistance to the ambient fluid 62, e.g. air. A thermally insulating material 92 thermally separates the two radiator parts 48 and 91, thus allowing different temperatures on these two radiator parts, as required for better performance of the implantable unit 60 and wearable TEG 90. A thermally insulating wall 93 encapsulates the, optionally micromachined, chips of the TEG 90.

As an example of a device powered by TEG 90, a wireless alarm node is shown in Fig. 7. The wireless alarm node can provide an alarm signal on a nearby receiving station through a wireless link. For this purpose, an antenna 88 is shown, as an example, manufactured on a thermally insulating element, e.g. ring 87. The radiator 85 for dissipating heat from the thermally conductive element 84 is not shown in Fig. 7 (it is, however, illustrated in Fig. 6), but it can, for example, be placed on another part of the thermally conductive element, e.g. thermal ring 84. Positioning sensor(s) can be placed in one of the wearable components. As an example, two such positioning sensors are shown in Fig. 7. The first positioning sensor is a Hall sensor 101 for detecting the presence of a magnetic field in at least one magnet 102 located in at least one of the implanted components, e.g., in an implanted device powered by implantable unit 60. As an example, in Fig. 7 magnets 102 are located in the unit 60 allowing some degree of misalignment of the wearable unit 70 with the implantable unit 60. The misalignment should preferably be as small as possible. In embodiments of the present invention, the misalignment is not larger than the difference in size between the Hall sensor 101 and the area covered by the magnets 102. Misalignment of the wearable unit 70 with respect to implantable unit 60 will cause a decrease of the magnetic field in the Hall sensor 101 and in case the misalignment exceeds a pre-determined allowable misalignment value the electronics can generate an alarm signal. An alarm signal can also be generated when the wearable components 70, 90, 81 are not attached to the skin 59. The second positioning sensor shown in Fig. 7 is a coil 103 (or coils), which in addition can be used for the exchange of information between the wearable and implanted devices and for further transmission of this information. As an example, in Fig. 7 the coil 103 in an external or wearable unit and the coil 104 in an embeddable or implantable unit can communicate with each other, as can the implanted (not illustrated) and wearable devices, e.g. electronic component 81, powered respectively by TEGs 40 and 90. In addition, the coils 103 and 104 can confirm proper positioning of the wearable unit 70; when both coils are sufficiently close to each other, there can be a strong communication signal between them. In case of improper positioning, there is weak communication signal or no communication signal at all. In this case the wearable device, e.g. electronic module 81, can generate an alarm and transmit an alarm signal, e.g. to an external receiver (not illustrated). In addition, other information such as for example the power generated by the implantable unit 60, can also be transmitted by the wearable device 100. Where components of the wearable device 100 are touching the skin 59, they may be supplied with narrow, e.g. 0.2-0.5 mm wide, radial grooves on the surface that is in contact with the skin 59, for improved evaporation of sweat vapour (not shown in Fig. 7, but similar to what is shown in Fig. 6).

An advantage of the TEG according to certain embodiments of the present invention is the possibility to use efficient implantable or embeddable units which are substantially smaller, and substantially thinner than prior art devices for a given output voltage and/or power. The reason is that prior art implantable TEGs rely only on the low temperature differences existing naturally in the body, while TEGs according to embodiments of the present invention result in a larger difference in temperature between the hot plate and the thermal matching plate due to redirection of the heat flows (as e.g. illustrated in Fig. 2 for a particular embodiment). The heat flow through the first unit 60 can, for example, be a factor of 2 to a factor of 10 larger as compared to prior art solutions.

In certain embodiments of the present invention the TEG 40, in particular the implantable or embeddable unit thereof, can be made sufficiently thin (e.g. a few millimetres) to allow the implantable unit to be embedded, for example, in a pipe with minimal disturbance of a flow of a fluid in the pipe, or for allowing implanting the implantable unit into the body of, e.g. mid-size or small-size birds and animals, or e.g., into the head, arms, forearms, legs and lower legs of human beings, i.e. into parts of the human body where there is not much space available for implants.

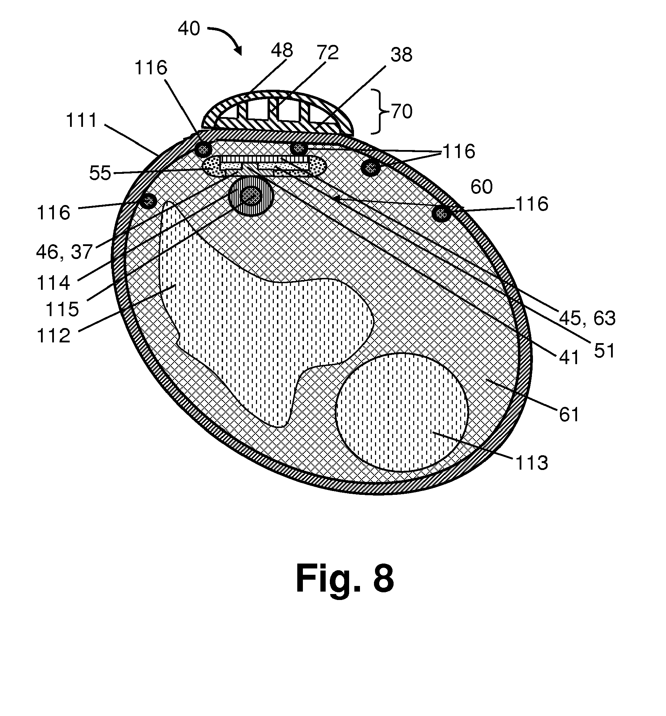

As an example, the TEG 40 illustrated in Fig. 8 comprises a 1.8 mm-thin implantable unit 60, which is a typical thickness of two thermopile chips 45, 46. The unit 60 illustrated in Fig. 8 is implanted, as an example, in a wrist, covered with skin 111. The Figure also shows a radial bone 112, elbow bone 113, radial artery with its wall 114 and arterial blood 115, and also some veins 116. At least one of the chips 45, 46 has a spacer 41 or is supplied with a spacer 41 to provide a distance in between the chips. The thermopile chip 46 simultaneously serves as a hot plate 37. The wearable unit 70 comprising a cold plate 38 and a radiator 48 is attached to a wrist strap or a watch strap (not shown). The fins/pins 72 made in the plate 38 also partially perform the function of the radiator 48, while the ambient air freely passes through the holes in between the parts of radiator 48. Elements of Fig. 8 not described here in detail are as described with respect to other embodiments and with reference to other drawings.

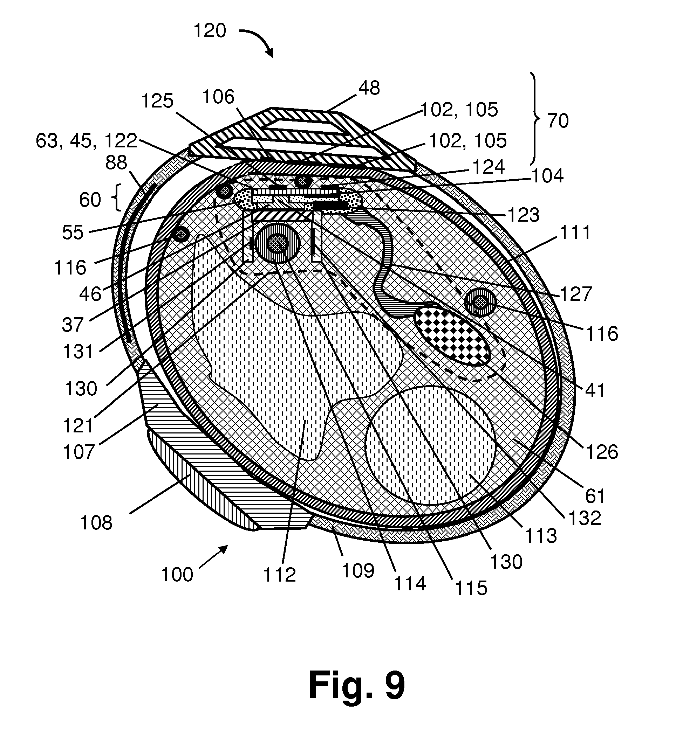

Another application is illustrated in Fig. 9, which shows a device 120 comprising a wearable device 100 and an implanted part 121. The implantable unit 60 comprises a thermopile chip 46, in which a thermopile is fabricated on a spacer 41. The implanted unit 60 also comprises a thermal matching plate 63, which can, for example, be made of semiconductor material such as silicon and which comprises a microelectronic chip 122 with electronics for implanted part 121. A charge storage element 123, such as e.g. a supercapacitor, is encapsulated inside the implantable unit 60 with thermally insulating material 55. A planar coil 104 on chip 122 is used to communicate to at least one of coils 102 at an external or wearable unit 70. Instead of an inductive link, another suitable type of link e.g. a light link can be used because the skin has a good transparency for visible and near-infrared light. Therefore, a light emitting diode 124 can be provided in chip 122, preferably at its outer side as shown, while one or more photodiode(s) 105 can be provided in the wearable unit 70 to receive the signal from the diode 124. For transmission of the data to the implantable unit 60, a similar method can be used, wherein at least one light emitting diode 106 and at least one photodiode 125 are provided. The electrical interconnections of diodes 124, 125 to electronics and the power supply are preferably made using through-chip interconnects (not shown). As an example of an implanted part 121, a pulse oximeter is shown, comprising thermally insulating holders 130 which have a similar function as a thermally insulating element 64 in other embodiments, surrounding the thermal matching plate 63. It also comprises light emitting diodes 131 comprising at least two diodes radiating at different wavelengths, and at least two photodiodes 132 receiving light from the diodes 131. It also comprises the electronic module (in the device shown, the electronic module is comprised in the chip 122). As a further example of an implanted device, a drug delivery device part 126, also powered from the implantable unit 60 is shown. The implantable unit 60 can for example be connected to the drug delivery device part 126 with a flexible or stretchable cable 127, for transmission of signals and electrical power. Charge storage elements 123, the electronic module(s) such as module 122, and other elements shown in unit 60 can be placed in this case into the part 126, if preferred. In the example shown, the wearable device comprises a wearable unit 70 and a watch-like unit 107 with a dial/display 108 placed in the wrist/watch strap 109. The watch-like unit 107 is used as a human interface device, as a control device and may be supplied with buttons allowing the user to immediately check the pulse oximetry data, or to perform other functions such as delivery of drugs from the drug delivery device part 126 into, e.g. a nearby artery or vein 116. A wearable device 100 can also be used for generating alarm signals warning the user, e.g. in case that at sub-zero ambient temperatures the temperature of arterial blood is too low and additional physical activity is immediately needed to warm the extremities and prevent frostbites. For this purpose, a temperature sensor (not shown) can be added to implanted parts 126 or 37, or 130. An antenna 88 may be embedded into a wrist strap 109 for one- or two-way communication with a nearby base station or with a long-distance wireless device such as a cell phone. The power autonomy for a wearable device 100 can be achieved using a battery, or using self-powering of the device for example by means of photovoltaic cells (not illustrated) that may for example be located on a radiator 48, or/and strap 109, or/and parts like the watch-like unit 107, or the dial/display 108. The radiator 48, or/and strap 109, or/and watch-like unit 107 can also comprise an additional wearable TEG such as TEG 90 shown in Fig. 7.

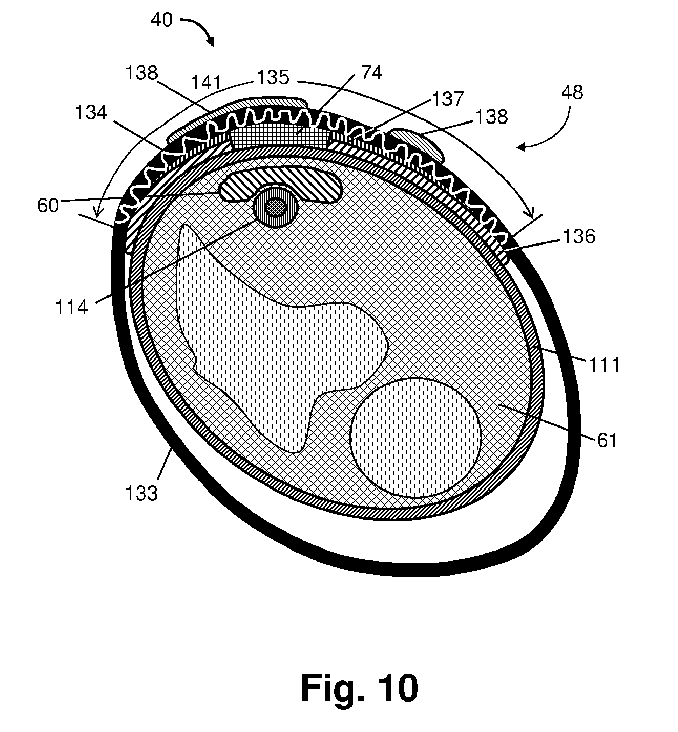

In the examples presented above, a rigid wearable device 100 or a rigid radiator 48 is used. However, in certain embodiments of the invention, flexible or stretchable radiators or entire wearable units can be advantageously used instead of rigid ones. This is illustrated in Fig. 10, which illustrates the section of a forehand surrounded by clothes 133, such as e.g. a sleeve of a shirt. Because the clothes 133 are made of thermally insulating materials, thermally conductive threads 134 (shown schematically as a white curved line in Fig. 10) can be added into the clothes, during fabrication of the clothes or afterwards. The threads 134 serve both to provide heat transfer through the cloth 133 (i.e. they perform the function of the outer thermal shunt 74), and as a radiator 48. As they are thin, flexible and stretchable this is much more convenient for the user. Because of preferable dense filling of the cloth 133 with threads 134, the thermally insulating threads of e.g. cotton remaining in between the threads 134 can also actively participate in a heat exchange with the ambient air and, therefore, the entire zone 135 wherein the threads 134 are added, effectively serves as a radiator 48. The direct heat transfer from the skin 111 to the radiator 48, however, would dramatically deteriorate the performance of such radiator 48. Therefore, a thermal insulation 136 made of any thermally insulating material, is preferably added between the skin 111 and the radiator 48 at least in the zone 135, and optionally even in a larger zone as shown in Fig 10. The zone 135 or the thermal insulation 136 can also be separated from the skin 111 with a layer of fluid like air, which can be done, e.g. using hair-like threads, or other small elements like several mm-tall pillars, etc. (not shown) sticking out from the cloth 133 towards the skin 111. As in the cases considered above, an additional thermally conductive spacer or a thermal shunt 74 can be added to improve heat transfer from the zone of the skin 111 over the implantable unit 60 into the radiator 48. The outer surface of this thermal shunt 74, if not coated with the cloth 133, can serve as a part of the radiator 48. The thermal insulation 136 further helps to partially redirect the heat flow normally occurring on the skin 111 near implantable unit 60 into the shunt 74 and then further into the radiating surface (zone 135). Depending on the particular dimensions and materials used in the device of Fig. 10, the heat transfer from the thermal shunt 74 to the most distant places of zone 135 may be complicated due to insufficient thermal conductance through the threads 134. Therefore, a rigid, or, preferably, flexible thermally conductive plate 137, or additional wires or bands can be added in between the insulation 136 and threads 134. Similarly thermally conductive elements 138 can be added on the outer surface of the clothes 133. The thermal contact in between the components 137, 138 and the zone 135 of the radiator is preferably good. Therefore, e.g., thermally conductive glue can be used for attaching these components, or/and e.g. through-cloth thermally conductive means like metal pins can be used to improve their thermal interconnection. If outer garment is worn on top of the one shown in Fig. 10, threads 134, thermally conductive components 137, 138, 74 and isolation 136 can be implemented into the outer garments providing alignment with the inner clothes and devices by design, or by using sticking layers, Velcro, magnets, buttons, etc. The shunt 74 preferably has a good thermal contact with the skin 111. It may be sticking to the skin 111, e.g. using changeable sticking tape like medical strips. Also, some springs, metal or plastic ones, or rubber-like threads/bands can be added into/on/under the garment providing tight attaching of shunt 74 to the skin 111 over the implanted unit 60, or over implanted device 121. Despite the less efficient performance of such radiators 48 in the garment as compared with the rigid ones described above, they can be much more comfortable, lighter and preferable for a wearer, e.g. in case of an implanted cardiac pacemaker. In principle, they can be made in such a way that the presence of an implanted unit 60 or device 121 cannot be seen, thereby making such devices extremely acceptable psychologically. Radiators fabricated in garment and caps can be used with all types of the TEG 40, units 70, 120 and 121 according to embodiments of the present invention, as well as with other possible implementations.

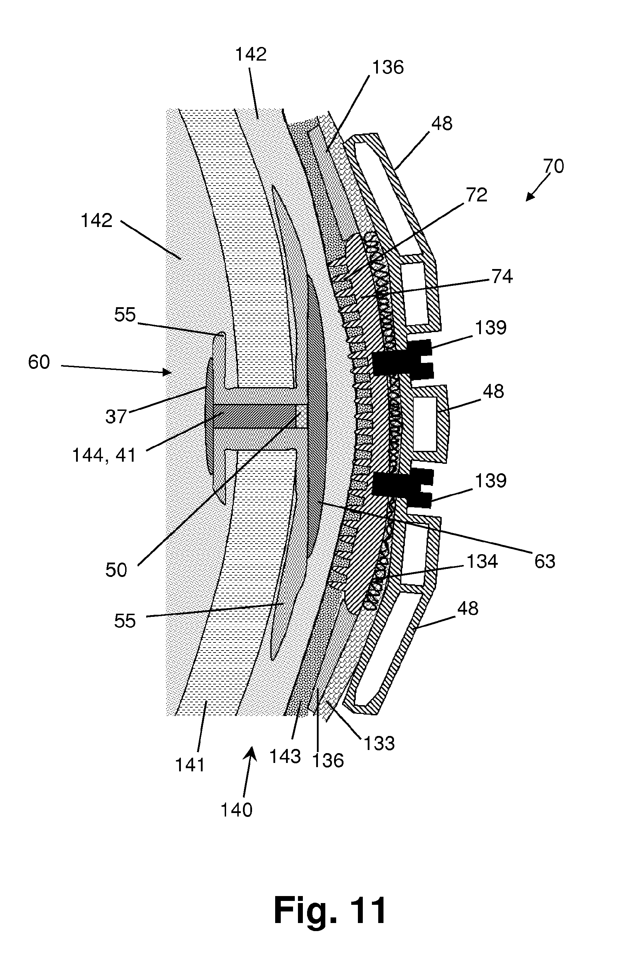

Fig. 11 illustrates another embodiment of the present invention. As shown in Fig. 11, the performance of a TEG 40 in the head 140 of a person or an animal can be enhanced by adding thermally conductive rods 144 (acting as thermally conductive spacers 41) penetrating through the scalp bones 141, the rods 144 being placed either (i) in between a thermopile unit 50 implanted above/in/below the scalp and a thermal matching plate 63 implanted in between the scalp 141 and the skin (not shown), or/and (ii) in between a thermopile unit 50 implanted above/in/below the scalp 141 and a hot plate 37 (as shown). In Fig.11, 142 is the soft tissue, 139 is a thermally conductive screw or another thermal connector connecting a radiator 48 and a plate 74 featured with pins 72 to thermally shunt the natural thermal isolation of the head, e.g. hair 143. The thermal conductance between the radiator 48 and the plate 74, which both may be made in a cap 133, is further enhanced by providing thermally conductive wires 134, while the radiator 48 serves as a decoration element for the cap 133. For comfort, while sleeping, or for example when swimming, the cap 133 can be replaced with an equivalent head strap featuring the same elements as shown in wearable unit 70 in Fig. 11. Wearing a wearable unit 70 may not always be necessary. For example, wireless sensors may be used to inform the wearer that there is enough energy stored in a charge storage device and temporarily there is no need to wear the wearable unit 70. Wireless sensors may also be used to recommend wearing the wearable unit 70, for example when there is little charge stored in the charge storage element(s), and/or when the power generation (over an hour, or over a day, or over more prolonged period of time, whatever is needed) is not enough to power an implanted device.

It is to be understood that the embodiments described herein are just a few examples illustrating the present invention. Alternative embodiments where the thermopile unit are placed external to the body and the cold plate and/or radiator are embeddable are also included in the present invention.

All shown elements can be used in different combinations, quantities and sequences. For example, the type and the number of thermopiles and thermopile stages may be different; the shape and relative size of the elements can be different; a protection ring may be used or not. The particular design may depend on many factors such as for example the power requirements, the necessity of continuous generation of power or not, ambient conditions (temperature, type of a fluid 62, weather conditions), the particular wearer of the device, and other factors. The examples described above wherein the TEG 40 is used on endotherms are only given as an example.

Other applications are possible, for example a TEG 40 according to the present invention may be used on e.g. a plastic pipe with an embeddable unit for being embedded into the pipe, while an external unit is for being placed on its outer surface. The embeddable unit may be any of the first or second units, while the external unit is the other one of the first or second units. In particular embodiments of the present invention, where the body is a mechanical structure, "embedding a unit" means that that unit is placed at one side of the mechanical structure, e.g. at the inside of a tube or pipe. This includes completely embedding the unit in the wall of the mechanical structure, or including it partly in the wall and leaving it partly sticking out thereof at one side, or placing the unit completely at one side of the wall of the mechanical structure, e.g. at the inner side of the mechanical structure. Hence the embedded unit may not be embedded in a solid body, but may alternatively be embedded in a fluid such as for example a cooling liquid or a gas which is present at one side of the wall of the mechanical structure. The other unit, intended to be the external unit, is then placed at the other side of the wall. At least part of the wall is present between the first and the second unit. On top of the wall, also part of the body (which may include a solid material but also a fluid) may be present between the first and the second unit. In such particular cases, the first and second units are each located at opposite sides of a wall of the mechanical structure, e.g. a tube wall. The external unit may be adapted and provided for being placed at the outer side of a tube or pipe, and the embeddable unit may be adapted and provided for being placed at the inner side of the tube or pipe.

In such applications, the hot plate 37 can be shaped as a radiator as well, or it may be supplied with a radiator, while the outer surface of unit 60, i.e. of a plate 63 may have thermally conductive fins/pins like 72, 77, to penetrate into the body of such plastic pipe for decreasing its thermal resistance in between units 60 and 70. Different types of electronic modules and different charge storage elements such as capacitors, supercapacitors or batteries can be added. They can be placed inside, attached to or positioned nearby any of the shown components. The direction of the heat flow can be different from the one described above. Even in case of endotherms such as human or animal beings, at ambient temperatures exceeding the skin temperature or at a high level of irradiation (e.g. sunlight), the heat flow can be from the ambient into the TEG 40. To vary the heat flow depending on the conditions of the object 61, e.g. an endotherm, or of the fluid 62, the radiator(s) 85, 48, or the parts supplied with fins/pins 72 such as a plate 38 (Fig. 4), can be made easily removable or attachable. The same applies to thermally conductive element, e.g. ring 84 and unit 70. Mechanical or magnetic clamps are just examples of possible ways of connecting such multicomponent wearable elements. Other possibilities are attaching them to a strap, garment or other object for fixing the wearable components of a TEG 40 on the object 61, e.g., on a human or animal being. The outer surfaces of embeddable unit 60 in case it is implanted, e.g. in a human or animal body, are made of biocompatible materials such as for example platinum, titanium, parylene, silicon dioxide, silicon nitride, or of such materials as foam, glass foam, silicone foam, polyurethane foam. The inner components of the embeddable unit 60 and device 121, if properly encapsulated, can include any other materials, i.e. not only biocompatible materials. The biocompatibility issue is preferably also taken into account for the wearable or external units 70. Preferably the surfaces that are in contact with the skin are made non-irritating even after prolonged wearing of the device. This can for example be done by providing a thin layer or coating of a biocompatible material.

Implanting the unit 60 into the body of an endotherm at a location close to the body inner organs (core of the body), e.g. the brain, liver, heart, or close to arteries may allow further increase of the generated power. Such location of implants can for example be useful for powering e.g. brain stimulators or pacemakers.

The signal processing can be performed partially or completely either in one of the electronic implanted/embedded units, or/and in any of the wearable units, or/and in another remote device such as a base station.

As is clear from the operation principles of a TEG 40 according to embodiments of the present invention, it can be used on cold-blooded animals and non-heated objects in case of ambient temperature variations, which result (at least part time) in a temperature difference in between an object 61 and the surrounding fluid 62. For example, a TEG 40 comprising an implantable unit implanted into a crocodile back, and a wearable unit placed on its back, would absorb both sunlight and heat from the surrounding air when the amphibian comes to a shore from the water, or when it is floating with a part of its back above the water level. Because of the larger heat flow through its skin in the area where the TEG 40 is located, the TEG would generate power more effectively than prior art devices until the body temperature reaches equilibrium. The opposite situation would occur when, after resting at a shore, the crocodile immerses into water. The larger heat flow from the body into the water would provide power generation until the amphibian reaches temperature equilibrium with the water. The energy properly stored in a charge storage device may be redistributed in time, providing functioning of the device 120 even at periods of time when there is temporarily no power generation. The wearable part 100 of a device 120 can also include an additional source of energy such as a primary or rechargeable battery, in case more energy is required than the amount of energy generated by the TEG, or in case there are periods of time when the power or voltage generated by TEGs 40, 90 is not sufficient for a particular application/device, or it is needed for safety/security, or for more autonomy.

The operation principles of the present invention can also be used for devices wherein a temperature difference is converted into useful electrical power by means of other mechanisms of energy conversion as described here, such as for example based on the thermionic principle or on the vacuum diode principle.

## Claims

1. A TEG device (40) comprising
- a first unit (60) comprising a thermopile unit (50), and
- a second unit (70) comprising a cold plate (38) and/or a radiator (48), one of the first or second units being an embeddable unit adapted for being embedded in an object (61), the other one of the first or second units being an external unit adapted for being placed on or near an interface between the object (61) and surrounding fluid (62), the first unit (60) and the second unit (70) being adapted for being thermally connected to each other.

2. A TEG device (40) according to claim 1, furthermore comprising means (37, 38, 48, 63, 64, 84) for improving the heat flow through the first unit (60) thermally connected to the second unit (70).

3. A TEG device (40) according to claim 2, wherein the means for improving the heat flow comprises, at the first unit (60), a thermally conductive thermal matching plate (63), wherein the size of the thermal matching plate (63) is substantially larger than the size of the thermopile unit (50) in a direction parallel to the average plane of the matching plate (63).

4. A TEG device (40) according to claim 3, wherein the first unit (60) further comprises a thermally insulating element (64) surrounding the thermal matching plate (63) in a direction parallel to the average plane of the thermal matching plate (63), the size of the thermally insulating element (64) being larger than the size of the thermal matching plate (63).

5. A TEG device (40) according to any of claims 2 to 4, wherein the means for improving the heat flow comprises, at the first unit (60), a heat absorbing plate (37) wherein the size of the heat absorbing plate (37) is substantially larger than the size of the thermopile unit (50) in a direction parallel to the average plane of the heat absorbing plate (37).

6. A TEG device (40) according to any of claims 2 to 5, wherein the means for improving the heat flow comprises, at the second unit (70), a cold plate (38), wherein the size of the cold plate (38) is substantially larger than the size of the thermopile unit (50) in a plane parallel to the average plane of the cold plate (38).

7. A TEG device (40) according to claim 6 in as far as dependent on claim 4, wherein the size of the thermally insulating element (64) is larger than the size of the cold plate (38) of the second unit (70) in a plane parallel to the average plane of the thermal matching plate (63).

8. A TEG device (40) according to any of claims 6 or 7, wherein the second unit (70) comprises a thermally conductive element (84) surrounding the cold plate (38) in a direction parallel to the average plane of the cold plate (38).

9. A TEG device (40) according to claim 8, wherein the size of the thermally conductive element (84) is larger than the size of the thermal matching plate (63) of the first unit (60) in a plane parallel to the average plane of the cold plate (38).

10. A TEG device (40) according to any of the previous claims, furthermore comprising alignment structures (101, 102; 103, 104) to align the second unit (70) with the first unit (60).

11. A TEG device (40) according to any of the previous clams, furthermore comprising signal transmitters and receivers (103, 104) to provide for communication between the first unit (60) and the second unit (70) and/or with a remote device.

12. Use of a TEG device (40) according to any of claims 1 to 11 for powering an embedded device (126).

13. Use of a TEG device (40) according to claim 12, wherein the embedded device is embedded into a mechanical structure.

14. A unit (70) of a TEG device (40) comprising a thermopile unit (50) or a cold plate (38) and/or a radiator (48), wherein the unit (70) is adapted for being placed on or near an interface between an object (61) and surrounding fluid (62), is adapted for being thermally connected to an embedded unit (60) embedded in the object (61).
